# EUROPEAN PATENT APPLICATION

(11) **EP 4 718 210 A1**
(43) Date of publication of application: **01.04.2026**
(21) Application number: 25205286.5
(22) Date of filing: 29.09.2025
(51) Int. Cl.: G06F 1/20, H04L 49/40

(54) **DUAL NETWORK CHIP LAYOUT FOR A LARGE MODULAR SYSTEM**

(30) Priority: 30.09.2024 US 202418902145
(71) Applicant: Arista Networks, Inc., Santa Clara, CA 95054 (US)
(72) Inventor: Kim, Daehwan Daniel, Santa Clara, CA, 95054 (US); Chan, Jason, Santa Clara, CA, 95054 (US); Ho, Man Him Andrew, Santa Clara, CA, 95054 (US); Soderberg, Paulmer, Santa Clara, CA, 95054 (US)
(74) Representative: Hoffmann Eitle

(57) **Abstract**

A "back-to-back" arrangement of printed circuit boards (PCBs) is provided. Network processors are mounted to the front sides of the PCBs. The network processors are connected to a plurality of nodes by a plurality of signal channels. More particularly, a first subset of the signal channels connects a network processor on a first of the back-to-back PCBs to the plurality of nodes and a second subset of the signal channels connects a network processor on the second of the back-to-back PCBs to the plurality of nodes. Each of the plurality of signals channels is configured to satisfy an insertion loss requirement.

## Description

### TECHNICAL FIELD

This disclosure relates generally to computer system architecture. More particularly, embodiments relate to network devices with multiple network chips.

### BACKGROUND

Network devices, such as switches, routers, gateways, and other types of network devices, may include network processors to handle forwarding decisions for forwarding traffic (e.g., to handle Layer 2 switching or Layer 3 switching/routing). In high-capacity network devices, the network processors may be implemented as application specific integrated circuits (ASICs). An ASIC can be orders of magnitude faster than a programmed central processing unit (CPU) for forwarding packets.

As networks grow and network traffic increases, there is an increasing demand for network devices that can connect more computing devices together. The network processors used to handle traffic in network devices, however, have limited bandwidth to handle connections.

### BRIEF DESCRIPTION OF DRAWINGS

The drawings accompanying and forming part of this specification are included to depict certain aspects of the disclosure. It should be noted that the features illustrated in the drawings are not necessarily drawn to scale. A more complete understanding of the disclosure and the advantages thereof may be acquired by referring to the following description, taken in conjunction with the accompanying drawings in which like reference numbers indicate like features.
FIG. 1A is a diagrammatic representation depicting a first view of one embodiment of a back-to-back arrangement of printed circuit boards (PCBs).
FIG. 1B is a diagrammatic representation depicting a second view of one embodiment of a back-to-back arrangement of printed circuit boards (PCBs).
FIG. 2 is a diagrammatic representation of one embodiment of a network device.
FIG. 3 is a diagrammatic representation depicting a first view of one embodiment of a fabric card.
FIG. 4 is a diagrammatic representation depicting a second view of one embodiment of a fabric card.
FIG. 5 is a diagrammatic representation of one embodiment of a node.

### WRITTEN DESCRIPTION

Embodiments of the present disclosure provide network devices that use multiple network processors interconnected to components to handle traffic forwarding between the components. In some embodiments, the use of multiple network processors allows the network device to support an increased number of connections. For example, two network processors of the same type can be used to double the number of connections compared to a single network processor of that type.

While multiple network processors could be connected on the same printed circuit board (PCB), this solution has several practical limitations. First, doing so may require a PCB that is too large to be practical or manufacturable. Second, even if the PCB could be manufactured, the longest traces on the PCB may introduce unacceptable insertion losses. Although retimers may be used to decrease insertion loss over long traces, retimers have several drawbacks including: increased power consumption, increased heat generation, increased board complexity, increased cost, and additional latency.

The present disclosure provides systems that use a "back-to-back" arrangement of PCBs to which network processors are mounted using ball grid array (BGA) packaging or other surface mount packaging or other mounting technology. The network processors, in some embodiments, comprise fabric processors (e.g., fabric application specific integrated circuits (ASICs)) or switching processors (e.g., switching ASICs). A switching network processor, such as a switching ASIC provides packet forwarding and may perform, for example, Layer 2 switching or Layer 3 routing. A switching network processor may also provide functionality such as quality of service, traffic shaping and policing, protocol handling and other network traffic processing functionality. A fabric network processor, such as a fabric ASIC, provides a fabric for transferring traffic between components of a modular network device. A fabric network processor implements internal forward of traffic between ingress and egress ports connected to different switching network processors (e.g., switching ASICs) or on different line cards.

The PCBs in the "back-to-back" arrangement are spaced apart with their front sides-that is, the sides to which the network processors are mounted-facing opposite directions. This arrangement can use PCBs that are smaller than would be required to support the same number and type(s) of network processors on a single PCB and facilitates the use of signal channels that meet the insertion loss requirements of components while reducing or eliminating the need for retimers.

In some embodiments, each PCB in the back-to-back arrangement includes a single network processor. However, to the extent multiple network processors can be included on a single PCB while meeting manufacturability and loss constraints, embodiments may include multiple network processors on one or more of the back-to-back PCBs.

According to one embodiment, the network processors of the back-to-back arrangement are connected to a plurality of nodes by respective signal channels. Examples of nodes include, but are not limited to network interfaces, network ports, and line cards. The signal channels between the network processors and the nodes comprise traces, signal channel cables, connectors or other components or combinations thereof to form electrical paths from the network processors to the nodes. In one embodiment, the signal channels between the network processors on the back-to-back PCBs and the nodes comprise signal channel cables, such as twinax signal channel cables, that run from board-to-cable connectors (e.g., terminal blocks) on the PCBs to node connectors (the connection to the nodes). The node connectors, according to one embodiment, are near package connectors (NPCs).

In one embodiment, the nodes are arranged in a row, spaced from the edges of the PCBs so that, for example, each node is, from a signal path perspective, approximately equidistant from the first network processor and the second network processor. As such, the lengths of the signal channel between the first network processor and a particular node and the second network processor and the same node are approximately the same. In one embodiment, the physical connections to the nodes (e.g., NPCs for connecting to the line cards, connectors to ports) are intersected by a plane (e.g., center plane) that passes between the pair of PCBs.

The network device is configured so that the signal channels satisfy the insertion loss requirements of each of the plurality of nodes. The insertion loss requirement for a signal channel between a network processor and a node will depend on the insertion losses and insertion loss specifications associated with the network processor and the node. For example, i) the network processor may have an associated insertion loss and insertion loss specification; and ii) the node may have an associated insertion loss and insertion loss specification. With respect to the node, for example, the node may include a node processor (e.g., a node ASIC) that has an associated insertion loss and insertion loss specification. Further the node may have an insertion loss for the portion of the signal channel between the node connection and the node processor.

Given the network processor insertion loss and the node insertion loss, an insertion loss requirement (allowable insertion loss) for the signal channel from the network processor to the node can be determined so that the total insertion loss of the complete channel between the network processor to the node processor satisfies the insertion loss specifications of the network processor and node processor. The components and arrangement of a signal channel can thus be selected so that the signal channel satisfies the insertion loss requirements of the network processor and the node. For example, signal channel cables, connectors, and traces can be selected so that the signal channel meets the insertion loss requirement.

In some embodiments, the PCBs are identical to each other and assembled on a common frame structure. The common frame structure may provide attachment holes for various components, such as NPCs, network processor attachment or other components.

Embodiments of the network device may include various heat management features, such as fans, heat transfer devices, etc. that are adapted to transfer heat away from the network processors. According to one embodiment, a heat exchanger, heat chimney or other heat transfer device may be disposed to transfer heat away from the PCBs. Further, signal channel cables may be routed to minimize impact on air flow while still satisfying the insertion loss requirements.

In some embodiments, the back-to-back configuration may be used in one or more communications modules of a network device, such as in one or more fabric cards or line cards of the network device. Using the example of a fabric card, the fabric card may include back-to-back PCBs with fabric ASICs disposed on the front sides of the back-to-back PCBs. Each of the fabric ASICs can be connected to each of a plurality of NPCs by a respective signal channel that is configured to meet a signal channel budget selected so that the overall channel between the fabric ASIC and a switching ASIC on a line card satisfies the insertion loss specification of the fabric ASIC and the switching ASIC.

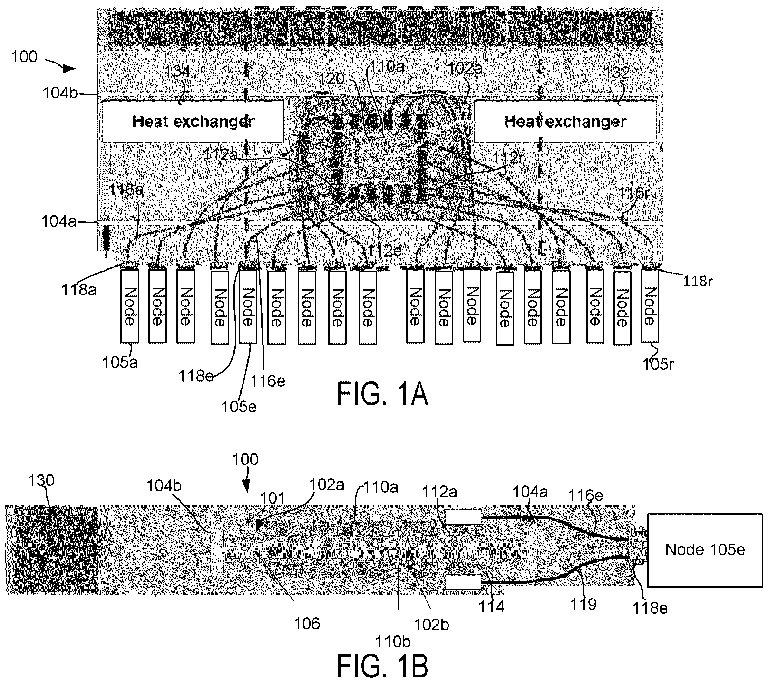

FIG. 1A is a diagrammatic representation of a network device 100 and FIG. 1B is a diagrammatic representation of a second view of network device 100 (FIG. 1A and FIG. 1B are referred to collectively herein as FIG. 1). Certain features or omitted from FIG. 1B for clarity.

Network device 100 includes a "back-to-back" arrangement 101 of PCBs that includes PCB 102a and PCB 102b. Each of PCB 101 has a front side (the "front side" of a PCB is also referred to as the "component side" or "primary side") and a rear side. According to one embodiment, PCB 102a and PCB 102b are identical PCBs. PCB 102a and PCB 102b are mounted to a common frame structure that comprises rail 104a and rail 104b and are spaced by a gap 106. In some embodiments, gap 106 is an air gap.

A network processor 110a is mounted to the front side of PCB 102a and a network processor 110b is mounted to the front side of PCB 102b using BGA packaging or other surface mount packaging or other mounting technology. According to one embodiment, each of network processor 110a and network processor 110b is a network ASIC, such as a switching ASIC or a fabric ASIC, that handles traffic forwarding and can provide other traffic management functionality.

Network processor 110a and network processor 110b of the back-to-back arrangement are connected to nodes 105a-105r (node 105a, node 105e and node 105r are indicated) by respective signal channels. Network processor 110a and network processor 110b provide traffic forwarding capability to forward traffic between the nodes. Examples of nodes include line cards, network ports, or other types of connected components between which traffic can be forwarded by the network processors.

The signal channels between network processors and nodes 105a-105r comprise traces, signal channel cables, connectors or other components or combinations thereof to form electrical paths from the network processors to the nodes. PCB 102a, for example, includes board-to-cable connectors 112a-112r (e.g., terminal blocks) which are electrically connected to network processor 110a by traces (board-to-cable connector 112a, board-to-cable connector 112e, and board-to-cable connector 112r are indicated in FIG. 1A; board-to-cable connector 112e is hidden by board-to-cable connector 112a in FIG. 1B). PCB 102b similarly includes board-to-cable connectors that are electrically connected to network processor 110b by traces (board-to-cable connector 114 is indicated in FIG. 1B). In the embodiment of FIG. 1, the board-to-cable connectors are arranged about the four sides of the respective network processor. This arrangement provides flexibility in signal channel cable routing and allows the signal channel cables to be fanned out to minimize their effect on air flow.

Signal channel cables connect between the board-to-cable connectors and node connectors 118a-118r. For PCB 102a, signal channel cables 116a-116r, such as twinax signal channel cables, connect between the board-to-cable connectors 112a-112r and node connectors 118a-118r (e.g., signal channel cable 116a connects between board-to-cable connector 112a and node connector 118a, signal channel cable 116e connects between board-to-cable connector 112e and node connector 118e, signal channel cable 116r connects between board-to-cable connector 112r and node connector 118r). Similarly, signal channel cables connect between the board-to-cable connectors of PCB 102b and the node connectors 118a-118r (e.g., signal channel cable 119 connects between a signal channel cable connector of PCB 102b and node connector 118e in FIG. 1B). According to one embodiment, node connectors 118a-118r are near package connectors (NPCs).

In the embodiment of FIG. 1 the node connectors 118a-118r and nodes 105a-105r are arranged in a row, spaced from the edges of the PCBs 102a, 102b so that, for example, each node connector 118a-118r or node 105a-105r is, from a signal path perspective, approximately equidistant from network processor 110a and network processor 110b. As such, the lengths of the signal channels from network processor 110a to a node connector 118a-118r or node 105a-105r is approximately the same as the length of the signal path from network processor 110b to the same node connector 118a-118r or node 105a-105r.

The signal channels between network processor 110a or network processor 110b and node 105a-105r are configured to satisfy the insertion loss requirements of the respective network processor and node. Using the example of the signal channel between network processor 110a and node 105a, i) network processor 110a has an associated insertion loss and insertion loss specification; and ii) node 105a has an associated insertion loss and insertion loss specification. With respect to node 105a, for example, the node may include a node processor (e.g., a node ASIC) that has an associated assertion loss and insertion loss specification. Further node 105a may have an insertion loss for the portion of the signal channel between the node connection and the node processor.

Given the insertion loss of network processor 110a and the insertion loss of node 105a, an insertion loss requirement (allowable insertion loss) for the signal channel from network processor 110a to node 105a can be determined so that the total insertion loss of the complete channel between network processor 110a to node 105a satisfies the insertion loss specifications of the network processor 110a and node 105a. The components and arrangement of a signal channel can thus be selected so that the signal channel satisfies the insertion loss requirements of network processor 110a and node 105a. For example, signal channel cable 116a, connector 112a, connector 118a, and traces can be selected so that the signal channel meets the insertion loss requirement.

A heat sink is coupled to the front surface of each of the network processors (e.g., heat sink 120 is coupled to network processor 110a) and is adapted to conduct heat away from the network processors. According to one embodiment, heat exchangers (e.g., heat exchanger 132, heat exchanger 134) are coupled to the heat sinks to further enhance heat management. Network device 100 includes fans 130 to produce airflow over and between the PCBs and to carry heat away from the heat sinks and heat exchangers.

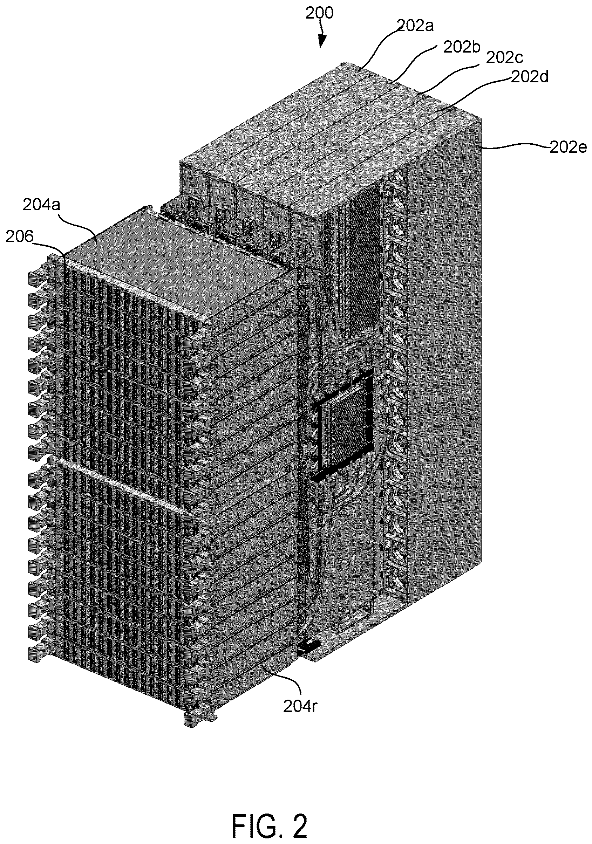

FIG. 2 is a diagrammatic representation of one embodiment of a modular network device 200 that includes a plurality of fabric cards (fabric card 202a, fabric card 202b, fabric card 202c, fabric card 202d, fabric card 202e) connected to a plurality of line cards 204a-204r. The line cards 204a-204r provide front-end ports for network connections (e.g., front-end port 206 is indicated). In one embodiment, each line card 204a-204r includes a switching ASIC for forwarding traffic between ports of that line card and traffic to/from the fabric cards and each fabric card 202a-202e includes a plurality of fabric ASICs for transferring traffic between line cards 204a-204r.

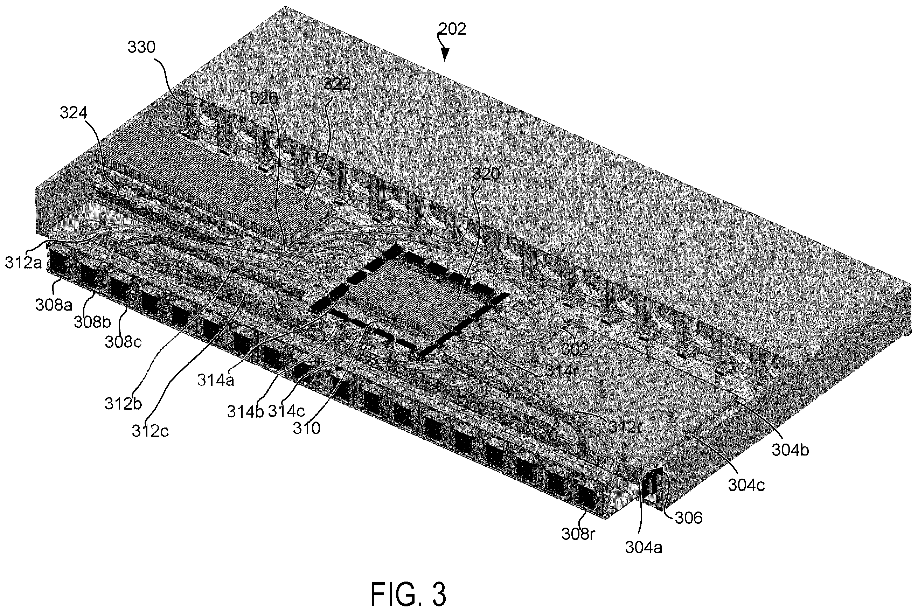

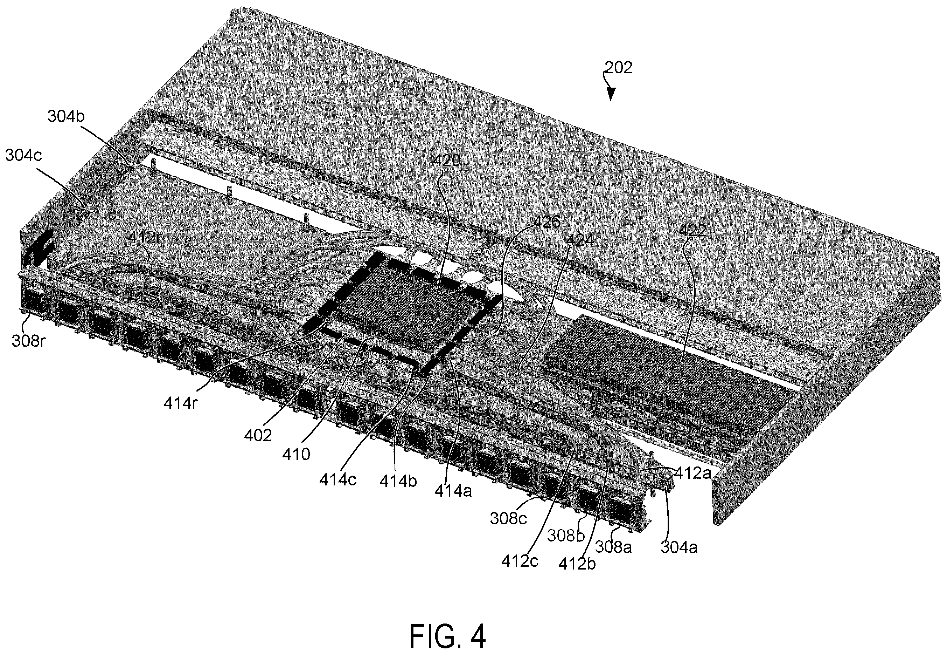

FIG. 3 is a diagrammatic representation of a first view of one embodiment of a fabric card 202 (e.g., fabric card 202a, fabric card 202b, fabric card 202c, fabric card 202d, or fabric card 202e) and FIG. 4 is diagrammatic representation of a second view of one embodiment of fabric card 202.

Fabric card 202 includes a "back-to-back" arrangement of PCBs that includes PCB 302 and PCB 402. A network processor 310 is mounted to the front side of PCB 302 and a network processor 410 is mounted to the front side of PCB 402 using BGA packaging or other surface mount packaging or other mounting technology. According to one embodiment, network processor 310 and network processor 410 are fabric ASICs.

PCB 302 and PCB 402 are coupled to a common frame structure that includes rail 304a, rail 304b and rail 304c. The common frame structure provides attachment holes for various components, such as PCBs, NPCs, or other components. Between the rails, PCB 302 and PCB 402 are separated by a gap 306. In some embodiments, gap 306 is an air gap.

Fabric card 202 includes a row of NPCs 308a-308r for connecting to line cards 204a-204r. In the embodiment of FIG. 3, the NPCs 308a-308r are arranged in a row, spaced from the edge of PCB 302 and PCB 402, with each NPC 308a-308r positioned, from a signal path perspective, approximately equidistant from network processor 310 and network processor 410. As such, the lengths of the signal channels from network processor 310 to an NPC 308a-308r is approximately the same as the length of the signal path from network processor 410 to the same NPC 308a-308r.

The network processors of fabric card 202 are connected to NPCs 308a-308r by respective signal channels (NPC 308a, NPC 308b, NPC 308c, and NPC 308r are indicated). The signal channels between the network processors and NPCs 308a-308r comprise traces, signal channel cables, connectors or other components or combinations thereof to form electrical paths from the network processors to the nodes. PCB 302, for example, includes board-to-cable connectors 314a-314r (board-to-cable connector 314a, board-to-cable connector 314b, board-to-cable connector 314c, and board-to-cable connector 314r are indicated in FIG. 3), which are electrically connected to network processor 310 by traces of PCB 302 and to NPCs 308a-308r by respective signal channel cables 312a-312r (signal channel cable 312a, signal channel cable 312b, signal channel cable 312c, and signal channel cable 312r are indicated in FIG. 3). Similarly, PCB 402 includes board-to-cable connectors 414a-414r (board-to-cable connector 414a, board-to-cable connector 414b, board-to-cable connector 414c, and board-to-cable connector 414r are indicated in FIG. 4), which are electrically connected to network processor 410 by traces of PCB 402 and to NPCs 308a-308r by respective signal channel cables 412a-412r (signal channel cable 412a, signal channel cable 412b, signal channel cable 412c, and signal channel cable 412r are indicated). According to one embodiment, signal channel cables 312a-312r and signal channel cables 412a-412r are twinax signal channel cables.

In the embodiment of fabric card 202 illustrated in FIG. 3 and FIG. 4, the board-to-cable connectors are arranged about the four sides of the respective network processor. This arrangement provides flexibility in signal channel cable routing and allows signal channel cables 312a-312r and signal channel cables 412a-412r to be fanned out to minimize their effect on air flow.

The line cards 204a-204r (FIG. 2) that connect to fabric card 202 by NPC 308a-308r may use network processors, such switching ASICs, that have a known assertion losses and insertion loss specifications. In addition, the line cards 204a-204r may have additional known insertion losses, such as those caused by a signal channel portion internal to the line card. Further, network processor 310 and network processor 410 may have an insertion loss specification and a known insertion loss.

Given the insertion losses of network processor 310, network processor 410, and line cards 204a-204r, an insertion loss requirement (allowable insertion loss) for the signal channels from network processor 310 and network processor 410 to the line card 204a-204r can be determined so that the total insertion loss of a complete channel between network processor 310 or network processor 410 to the network processor of the line card 204a-204r satisfies the insertion loss specifications of the network processor and node processor. The components and arrangement of the signal channels can thus be selected so that each signal channel satisfies the insertion loss requirements of the respective network processor 310 or network processor 410 and line card 204a-204r. For example, the traces of PCB 302 and PCB 402, signal channel cables 312a-312r, signal channel cables 412a-412r, board-to-cable connectors 314a-314r, board-to-cable connectors 414a-414r, and NPCs 308a-308r can be selected so that the signal channels between network processor 310 and line cards 204a-204r and the signal channels between network processor 410 and the line cards 204a-204r meet the insertion loss requirement.

Embodiments may include various heat management features, such as fans, heat transfer devices, etc. In the embodiment of FIG. 3 and FIG. 4, a heat sink 320 is coupled to network processor 310 to transfer heat away from network processor 310 and a heat sink 420 is coupled to network processor 410 to transfer heat away from network processor 410. Heat sink 320 is coupled to a heat exchanger 322 by heat pipe 324 and heat pipe 326 for the circulation of a cooling fluid (e.g., air, a liquid coolant) to remove heat from heat sink 320. Similarly, heat sink 420 is coupled to a heat exchanger 422 by heat pipe 424 and heat pipe 426 for the circulation of a cooling fluid to remove heat from heat sink 420. In one embodiment, heat exchanger 322 and heat exchanger 422 are positioned to be above the respective heat sink 320 and heat sink 420 during use, as illustrated, for example, in FIG. 2. Thus, heat may be transferred away from heat sink 320 and heat sink 420 using a thermal chimney. Fabric card 202 further comprises fans 330 to produce airflow over and between the PCBs and to carry heat away from the heat sinks and heat exchangers. As discussed above, the signal channel cables may be routed to minimize impact on air flow, while still satisfying the insertion loss requirements.

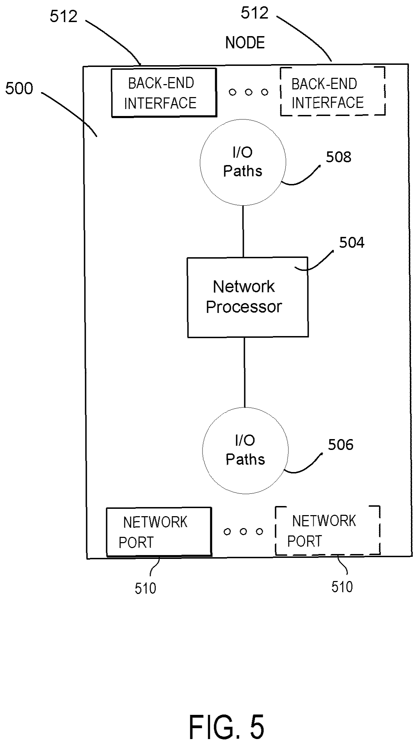

FIG. 5 depicts a diagrammatic representation of an example architecture of a node 500, such as a line card, according to some embodiments disclosed herein. Node 500 includes control circuitry such as a network processor 504. According to one embodiment, network processor 504 is a switching processor. In an even more particular embodiment, network processor 504 comprises a switching ASIC. Node 500 may receive data via input/output (I/O) paths 506 or I/O paths 508. I/O paths 506 and I/O paths 508 carry packet data to/from network processor 504. Network processor 504 may send and receive commands, requests, and other suitable data using the I/O paths 506 or I/O paths 508. In turn, I/O paths 506 connect network processor 504 to one or more network ports 510, such as front-end ports, to which other devices can be connected. These network ports may be any type of network interface, such as an RJ45 ethernet port, a coaxial port, etc. I/O paths 508 connect network processor 504 to one or more back-end interfaces 512. These interfaces are compatible with the node connectors used by the back-to-back PCB arrangement (e.g., a node connector 118a-118r, a near package connector 318a-318r).

In this disclosure, specific embodiments have been described with reference to the accompanying figures. In the above description, numerous details are set forth as examples. It will be understood by those skilled in the art, and having the benefit of this Detailed Description, that one or more embodiments described herein may be practiced without these specific details and that numerous variations or modifications may be possible without departing from the scope of the embodiments. Certain details known to those of ordinary skill in the art may be omitted to avoid obscuring the description.

In the above description of the figures, any component described with regard to a figure, in various embodiments, may be equivalent to one or more like-named components shown and/or described with regard to any other figure. For brevity, descriptions of these components may not be repeated with regard to each figure. Thus, each and every embodiment of the components of each figure is incorporated by reference and assumed to be optionally present within every other figure having one or more like-named components. Additionally, in accordance with various embodiments described herein, any description of the components of a figure is to be interpreted as an optional embodiment, which may be implemented in addition to, in conjunction with, or in place of the embodiments described with regard to a corresponding like-named component in any other figure.

Throughout the application, ordinal numbers (e.g., first, second, third, etc.) may be used as an adjective for an element (i.e., any noun in the application). The use of ordinal numbers is not to imply or create any particular ordering of the elements nor to limit any element to being only a single element unless expressly disclosed, such as by the use of the terms "before", "after", "single", and other such terminology. Rather, the use of ordinal numbers is to distinguish between the elements. By way of an example, a first element is distinct from a second element, and the first element may encompass more than one element and succeed (or precede) the second element in an ordering of elements.

As used herein, the phrase operatively connected, or operative connection, means that there exists between elements/components/devices a direct or indirect connection that allows the elements to interact with one another in some way. For example, the phrase 'operatively connected' may refer to any direct (e.g., wired directly between two devices or components) or indirect (e.g., wired and/or wireless connections between any number of devices or components connecting the operatively connected devices) connection. Thus, any path through which information may travel may be considered an operative connection.

While embodiments described herein have been described with respect to a limited number of embodiments, those skilled in the art, having the benefit of this Detailed Description, will appreciate that other embodiments can be devised which do not depart from the scope of embodiments as disclosed herein. Accordingly, the scope of embodiments described herein should be limited only by the attached claims.

The disclosure in the application also includes the following numbered clauses:
1. An apparatus with multiple network processors, comprising:
   a first printed circuit board (PCB) having a front side and rear side;
   a first network processor disposed on the front side of the first PCB;
   a second PCB having a front side and a rear side, the second PCB spaced from and arranged in a back-to-back configuration with the first PCB;
   a second network processor disposed on the front side of the second PCB;
   a plurality of nodes; and
   a plurality of signal channels, the plurality of signal channels comprising a first subset connecting each of the plurality of nodes to the first network processor and a second subset connecting each of the plurality of nodes to the second network processor.
2. The apparatus of Clause 1, wherein each of the plurality of signals channels is configured to satisfy an insertion loss requirement.
3. The apparatus of Clause 1, wherein each of the plurality of signal channels comprises a cable.
4. The apparatus of Clause 3, wherein:
   the first PCB comprises first board-to-cable connectors arranged about the first network processor and wherein the cables of the first subset of the plurality of signal channels connect to the first board-to-cable connectors; and
   the second PCB comprises second board-to-cable connectors arranged about the second network processor and wherein the cables of the second subset of the plurality of signal channels connect to the second board-to-cable connectors.
5. The apparatus of Clause 4, wherein the cables of the plurality of signal channels are routed to allow air flows over the front side of the first PCB and over the front side of the second PCB.
6. The apparatus of Clause 5, further comprising a fan adapted to create the air flows.
7. The apparatus of Clause 1, wherein each of the plurality of nodes is spaced from the first PCB and the second PCB and wherein each of the plurality of nodes is intersected by a plane that passes between the first PCB and the second PCB.
8. The apparatus of Clause 7, wherein the plane is a center plane.
9. The apparatus of Clause 1, wherein the first PCB and the second PCB are spaced by an air gap.
10. The apparatus of Clause 9, further comprising a heat transfer device adapted to transfer heat away from the first PCB and the second PCB.
11. The apparatus of Clause 10, further comprising a frame, wherein the first PCB and the second PCB are mounted to the frame.
12. The apparatus of Clause 1, wherein each of the first PCB and the second PCB has a single network processor.
13. The apparatus of Clause 1, wherein the first network processor is a first network ASIC and the second network processor is a second network ASIC.
14. The apparatus of Clause 1, wherein the first network processor is a first fabric ASIC and the second network processor is a second fabric ASIC and wherein each of the plurality of nodes is a line cards comprises:
   a network port; and
   a switching ASIC, the switching ASIC having an insertion loss specification, wherein each of the plurality of signal channels satisfies the insertion loss specification.
15. The apparatus of Clause 1, further comprising a plurality of near package connectors connected to the plurality of nodes.
16. The apparatus of Clause 1, wherein the plurality of signal channels includes a longest signal channel, and wherein the longest signal channel satisfies an insertion loss specification.
17. A fabric card for a network device, the fabric card comprising:
   a first printed circuit board (PCB) having a front side and a rear side;
   a first fabric ASIC disposed on the front side of the first PCB;
   a second PCB having a front side and a rear side, the second PCB spaced from and arranged in a back-to-back configuration with the first PCB;
   a second fabric ASIC disposed on the front side of the second PCB;
   a plurality of near package connectors for connecting to line cards; and
   a plurality of signal channels, the plurality of signal channels comprising a first subset connecting each of the plurality of near package connectors to the first fabric ASIC and a second subset connecting each of the plurality of near package connectors to the second fabric ASIC.
18. The fabric card of Clause 17, wherein each of the plurality of signals channels is configured to satisfy an insertion loss requirement.
19. The fabric card of Clause 17, further comprising a heat transfer device adapted to transfer heat away from the first PCB and the second PCB, wherein:
   each of the plurality of signal channels comprises a cable;
   the cables of the plurality of signal channels are routed to allow air flows over the front side of the first PCB and over the front side of the second PCB;
   the first PCB comprises first board-to-cable connectors arranged about the first fabric ASIC and wherein the cables of the first subset of the plurality of signal channels connect to the first board-to-cable connectors; and
   the second PCB comprises second board-to-cable connectors arranged about the fabric ASIC and wherein the cables of the second subset of the plurality of signal channels connect to the second board-to-cable connectors.
20. A network device comprising:
   a fabric card, the fabric card comprising:
      a first printed circuit board (PCB) having a front side and rear side;
      a first fabric ASIC disposed on the front side of the first PCB;
      a first plurality of board-to-cable connectors arranged about the first fabric ASIC;
      a second PCB having a front side and a rear side, the second PCB spaced from and arranged in a back-to-back configuration with the first PCB;
      a second fabric ASIC disposed on the front side of the second PCB;
      a second plurality of board-to-cable connectors arranged about the second fabric ASIC;
      a plurality of near package connectors; and
      a plurality of signal channel cables, the plurality of signal channel cables comprising:
         a first subset connecting each of the plurality of near package connectors to a respective board-to-cable connector from the first plurality of board-to-cable connectors to connect the first fabric ASIC to each of the plurality of near package connectors;
         a second subset connecting each of the plurality of near package connectors to a respective board-to-cable connector from the second plurality of board-to-cable connectors to connect the second fabric ASIC to each of the plurality of near package connectors;
   a plurality of line cards connected to the fabric card by the plurality of near package connectors, each line card from the plurality of line cards comprising:
      a network port; and
      a switching ASIC.

## Claims

1. An apparatus with multiple network processors, comprising:
a first printed circuit board (PCB) having a front side and rear side;
a first network processor disposed on the front side of the first PCB;
a second PCB having a front side and a rear side, the second PCB spaced from and arranged in a back-to-back configuration with the first PCB;
a second network processor disposed on the front side of the second PCB;
a plurality of nodes; and
a plurality of signal channels, the plurality of signal channels comprising a first subset connecting each of the plurality of nodes to the first network processor and a second subset connecting each of the plurality of nodes to the second network processor.

2. The apparatus of Claim 1, wherein each of the plurality of signals channels is configured to satisfy an insertion loss requirement.

3. The apparatus of Claim 1 or Claim 2, wherein each of the plurality of signal channels comprises a cable.

4. The apparatus of any one of Claims 1-3, wherein:
the first PCB comprises first board-to-cable connectors arranged about the first network processor and wherein the cables of the first subset of the plurality of signal channels connect to the first board-to-cable connectors; and
the second PCB comprises second board-to-cable connectors arranged about the second network processor and wherein the cables of the second subset of the plurality of signal channels connect to the second board-to-cable connectors.

5. The apparatus of any one of Claims 1-4, wherein the cables of the plurality of signal channels are routed to allow air flows over the front side of the first PCB and over the front side of the second PCB.

6. The apparatus of any one of Claims 1-5, wherein each of the plurality of nodes is spaced from the first PCB and the second PCB and wherein each of the plurality of nodes is intersected by a plane that passes between the first PCB and the second PCB.

7. The apparatus of any one of Claims 1-6, wherein the first PCB and the second PCB are spaced by an air gap.

8. The apparatus of any one of Claims 1-7, further comprising a heat transfer device adapted to transfer heat away from the first PCB and the second PCB.

9. The apparatus of any one of Claims 1-8, further comprising a frame, wherein the first PCB and the second PCB are mounted to the frame.

10. The apparatus of any one of Claims 1-9, wherein each of the first PCB and the second PCB has a single network processor.

11. The apparatus of any one of Claims 1-10, wherein the first network processor is a first network ASIC and the second network processor is a second network ASIC.

12. The apparatus of any one of Claims 1-11, wherein the first network processor is a first fabric ASIC and the second network processor is a second fabric ASIC and wherein each of the plurality of nodes is a line card that comprises:
a network port; and
a switching ASIC, the switching ASIC having an insertion loss specification, wherein each of the plurality of signal channels satisfies the insertion loss specification.

13. The apparatus of any one of Claims 1-12, further comprising a plurality of near package connectors connected to the plurality of nodes.

14. The apparatus of any one of Claims 1-13, wherein the plurality of signal channels includes a longest signal channel, and wherein the longest signal channel satisfies an insertion loss specification.

15. The apparatus of any one of Claims 1-14, further comprising a fabric card for a network device, the fabric card comprising:
the first PCB; and
the second PCB.
